# EUROPÄISCHE PATENTSCHRIFT

(11) **EP 1 025 061 B1**
(45) Veröffentlichungstag und Bekanntmachung des Hinweises auf die Patenterteilung: **04.12.2013**
(21) Anmeldenummer: 98949975.1
(22) Anmeldetag: 27.08.1998
(51) Int. Cl.: C04B 35/491, H01L 41/187

(54) **HOCHLEISTUNGS-PIEZOKERAMIK**
HIGH-PERFORMANCE PIEZOELECTRIC CERAMIC
CERAMIQUE PIEZO-ELECTRIQUE HAUTE PERFORMANCE

(30) Priorität: 05.09.1997 DE 19738793
(43) Veröffentlichungstag der Anmeldung: 09.08.2000
(73) Patentinhaber: CeramTec GmbH, 73207 Plochingen (DE)
(72) Erfinder: HELKE, Günter, D-91207 Lauf (DE)
(74) Vertreter: Uppena, Franz
(86) Internationale Anmeldenummer: PCT/EP1998/005439
(87) Internationale Veröffentlichungsnummer: WO 1999/012865

(56) Entgegenhaltungen:
- EYRAUD: J. OF SOLID STATE CHEMISTRY, Bd. 53, 1984, Seiten 266-272, XP002090047 in der Anmeldung erwähnt
- EYRAUD: ADVANCED CERAMIC MATERIALS, Bd. 1, Nr. 3, 1986, Seiten 223-231, XP002090048 in der Anmeldung erwähnt
- EYRAUD: FERROELECTRICS, Bd. 50, 1983, Seiten 103-110, XP002090049 in der Anmeldung erwähnt

## Beschreibung

Gegenstand der vorliegenden Erfindung ist ein piezoelektrisches Keramikmaterial auf Basis von Bleizirkonattitanat, das sich durch eine hervorragende thermische und zeitliche Stabilität der funktionellen Kenngrößen auszeichnet.

Für den Einsatz von Piezokeramik für Sensoren, insbesondere in der KFZ-Technik (Klopfsensoren, Drehraten-Sensoren, Rückfahrsensoren) sind Werkstoffe mit hoher piezoelektrischer Aktivität bei hoher thermischer und zeitlicher Stabilität (hohe Curie-Temperatur, geringen Temperaturkoeffizienten und niedrigen Alterungsraten) der funktionellen Kenngrößen erforderlich.

Für die Weiterführung der Entwicklung auf dem Gebiet der Vielschicht-Aktoren werden Piezokeramiken mit großen Deformationsdefekten und hoher Curie-Temperatur benötigt.

Piezokeramische Werkstoffe bestehen seit langem aus Zusammensetzungen auf der Basis der festen Lösungen (Mischkristalle) von Bleizirkonat (PbZrO₃) und Bleititanat (PbTiO₃). Vielfältige Modifikationen des Grundsystems sind durch Substitution und/oder Zusatz von Metallionen in begrenzten Konzentrationen möglich, wenn die betreffenden Ionen Voraussetzungen bezüglich Wertigkeit, lonenradius und Charakter der chemischen Bindung erfüllen.

Unter Substitution im ursprünglichen Sinne ist der partielle Ersatz der Ionen Pb²⁺ bzw. Zr⁴⁺ und Ti⁴⁺ durch Ionen gleicher Wertigkeit und ähnlicher Ionenradien, wie Ba²⁺, Sr²⁺, Mg²⁺ bzw. Sn⁴⁺ zu verstehen. Solche Substitutionen bewirken einerseits eine Erhöhung der piezoelektrischen Aktivität, können andererseits aber auch die thermische Stabilität des piezoelektrischen Zustandes beeinträchtigen.

Eine Modifikation der Grundzusammensetzung durch Dotierung mit Ionen abweichender Wertigkeit gegenüber den ursprünglichen Ionen führt zu einer weitergehenden Diversifizierung der dielektrischen und elektromechanischen Eigenschaften.

Ionen aus der "Weichmacher"-Gruppe La³⁺, Bi³⁺, Sb⁵⁺, Nb⁵⁺ wirken im Grundsystem als Donatoren und ergeben Piezokeramiken, die sich durch eine große Dielektrizitätskonstante und eine hohe elektromechanische Aktivität auszeichnen, aber auch durch hohe dielektrische und mechanische Verluste sowie eine Abhängigkeit der spezifischen Kenngrößen von starken elektrischen Feldern und mechanischer Belastungen gekennzeichnet sind.

Eine Stabilisierung der Piezokeramiken auf der Basis von Bleizirkonattitanat ergibt die Dotierung mit Ionen aus der "Härter"-Gruppe K⁺, Fe³⁺, Al³⁺: Diese Ionen wirken als Akzeptoren, und in Wechselwirkung mit den Ionen des Grundsystems bewirken sie eine Verringerung der dielektrischen und mechanischen Verluste, führen aber auch zu einer Verringerung von Dielektrizitätskonstante, piezoelektrischer Aktivität und spezifischem elektrischen Widerstand.

Durch gekoppelte Substitution von Ionen der Gruppe der "Weichmacher" mit Ionen der Gruppe der "Härter" wiederum wird es möglich, die Stabilität von Piezokeramiken auf der Basis von Bleizirkonattitanat bei Aufrechterhaltung der piezoelektrischen Aktivität und der hohen Dielektrizitätskonstante deutlich zu erhöhen.

Den gestiegenen Anforderungen der praktischen Anwendung von Piezokeramiken versuchte man schließlich durch Multikomponenten-Systeme gerecht zu werden, in denen bleihaltige Ionenkomplexe ("komplexe Verbindungen") mit der allgemeinen Formulierung PbB'_{1-α}B"_{α}O₃, mit B': 5- bzw. 6-wertige Kationen und B": 2-wertige Kationen, (α = 1/3 oder 1/2 in Abhängigkeit von der Wertigkeit des Kations B', teilweise den Ionenkomplex Pb²⁺(Zr⁴⁺, Ti⁴⁺)O₃ ersetzen.

Durch Substitution einer oder mehrerer der komplexen Verbindungen, die auch als sog. Relaxor-Ferroelektrika bekannt sind, entstehen einphasige Mehrkomponenten-Systeme (z. B. als ternäre oder quaternäre feste Lösungen) mit Perowskitstruktur.

Zur Verbesserung der Eigenschaften von Bleizirkonattitanat-Keramiken führt auch die Substitution von bleifreien Verbindungen mit Perowskitstruktur wie BiFeO₃, KNbO₃, NaNbO₃, Na_{0,5}Bi_{0,5}TiO₃.

Diese Piezokeramiken gehören zur großen Familie der (keramischen) Ferroelektrika. Als keramische Ferroelektrika sind auch bleifreie Zusammensetzungen, wie (K, Na)NbO₃, (Sr₁₋ₓBaₓ)Nb₂O₆ bekannt.

Insgesamt existiert mit den unterschiedlichsten Modifikationen des Grundsystems der festen Lösungen von Bleizirkonattitanat eine große Zusammensetzungsvielfalt, mit der es in vielen Fällen möglich war, eine jeweils anwendungsgerechte Spezifikation der dielektrischen und elektromechanischen Eigenschaften piezoelektrischer Werkstoffe für unterschiedliche Wandlerfunktionen zu realisieren.

Aus [1] Eyraud, L., Eyraud, P., Mathieu, J. C., Claudel, B. "Effect of Simultaneous Heterovalent Substitutions on Both Cationic Sites on the Electrical Conductivitity and Ageing of PZT Type Ceramics" (Ferroelectrics 50(1983)103-1 10), [2] Eyraud, L. Eyraud, P. Claudel, B. "Influence of Simultaneous Heterovalent Substitutions in Both Cationic Sites on the Ferroelectlic Properties of PZT Type Ceramics" (J.Solid State Chem. 53(1984)266-272), [3] Ohenassion, H., Gonnard, P., Troccaz, L., Eyraud, L., Eyraud, P. "Characterisation de la stabilité d'un element piézoélectrique du type PZT sous compression uniaxiale rapide" (Revue Phys. Appl. 18(1983)479-486) und [4] Eyraud, L., Eyraud, P., Bauer, F. "Current Research in the Field of PZT Ceramics and Ferroelectric-Polymers" (Adv. Cer. Mat. 1(1986)3, 223-231) ist die Zusammensetzungsreihe
Pb_{0,995}Sr_{0,015}Ba_{0,005}K_{0,0025}Na_{0,0025}(ZrₓTi₁₋ₓNb_{0,02})O_{3(1+0,02)}
x = 0,52... 0,54
bekannt.

Die konkreten Zusammensetzungen wurden unkonventionell durch Oxalat-Mischfällung in einem naßchemischen Prozeß präpariert. Ziel dieser Arbeiten war die Herstellung von Zusammensetzungen mit sehr niedriger elektrischer Leitfähigkeit durch Kompensation der Wertigkeit von heterovalenten Substituenten und schließlich in der Stabilisierung der funktionellen Eigenschaften gegenüber größeren mechanischen Belastungen. Die optimale Konzentration der Substituenten wurde durch Trial und Error gefunden, und als beständigste Zusammensetzung bezüglich der mechanischen Belastbarkeit ergab sich die Formulierung mit dem Zr⁴⁺-Gehalt x = 0,53. Charakterisiert werden die Zusammensetzungen in [3] und [4]. Das Stabilitätskriterium für diese Zusammensetzungen war die Beständigkeit bezüglich mechanischer Belastung. Angaben zu Curietemperatur, Temperaturkoeffizienten und Alterungsraten wurden nicht gemacht. Die optimale Sintertemperatur wurde mit 1230 °C angegeben. Die in diesen Arbeiten zur Herstellung der Verbindungen verwendete naßchemische Präparation ist großtechnisch nur mit beträchtlichem Aufwand umsetzbar.

Die der vorliegenden Erfindung zugrundeliegende Aufgabe war, modifizierte Piezokeramiken auf der Basis von Bleizirkonattitanat mit hoher Depolarisationsfestigkeit bei hohen mechanischen (Stoß-)Belastungen (für Gaszünder) und insbesondere mit geringen Temperaturkoeffizienten und Alterungsraten der funktionellen Kenngrößen, hoher Curietemperatur (für Sensoren) sowie großem Deformationseffekt (für Aktoren) bereitzustellen. Dabei sollten diese Piezokeramiken über die konventionelle Mischoxid-Route synthetisiert und bei Temperaturen unter 1150 °C gesintert werden können.

Gelöst wurde diese Aufgabe durch ein piezoelektrisches Keramikmaterial auf Basis von Bleizirkonattitanat mit den Kennzeichen des 1. Anspruchs. Vorzugsweise Ausgestaltungen sind in den Unteransprüchen charakterisiert.

Überraschenderweise wurde festgestellt, daß beim Bleizirkonattitanat (mit Perowskitstruktur A²⁺B⁴⁺O₃) durch partielle Substitution mit ferroelektrisch aktiven Verbindungen die angestrebte Stabilisierung der Werkstoffe erreicht und gleichzeitig die Verringerung der Sintertemperatur ermöglicht werden kann.

Dazu werden die als Modifikationen von Bleizirkonattitanat (Perowskitstruktur A²⁺B⁴⁺O₃) an sich bekannten Erdalkalimetalle Sr²⁺, Ba²⁺, Alkali-metalle K⁺, Na⁺ und Metalle Nb⁵⁺, Sb⁵⁺, Ta⁵⁺ über bleifreie Verbindungen mit der allgemeinen Zusammensetzung

- A²⁺B'_{0,25}¹⁺B"_{0,75}⁵⁺O₃

für heterovalente Ionenkombinationen (gegenüber A²⁺B⁴⁺O₃) mit Perowskitstruktur über ternäre bzw. quaternäre feste Lösungen stöchiometrisch eingebaut. Gegebenenfalls kann zur Erhöhung der piezoelektrischen Aktivität der erfindungsgemäßen Zusammensetzungen auch mit einem Überschuß von "Weichmacher"-Ionen (Nichtstöchiometrie < 1 Gew.%) gearbeitet werden.

Die allgemeine Formulierung der so gebildeten erfindungsgemäßen ternären bzw. quaternären festen Lösungen sind:

(1-u)Pb(ZrₓTi₁₋ₓ)O₃-uA²⁺(B'_{0,25}¹⁺B"_{0,75}⁵⁺O₃(+wMe₂⁵⁺O₅)

Für das Kation A²⁺ kann zudem eine Kombination der Ionen Sr²⁺ und Ba²⁺ in einem bestimmten Konzentrationsverhältnis, vorzugsweise die Kombinationen Sr_{0.7}Ba_{0.3}, Sr₀.₇₅Ba_{0.25} oder Sr_{0,8}Ba₀,₂, besonders bevorzugt die Kombination Sr_{0,75}Ba_{0,25} stehen.

Die erfindungsgemäßen Keramikmateriallen können erhalten werden durch Modifikation von Bleizirkonattitanat mit komplexen, bleifreien Perowskiten der allgemeinen Zusammensetzung A²⁺B'_{0,25}¹⁺B"_{0,75}⁵⁺O₃ (Verbindung von Erdalkalimetallionen Ba²⁺, Sr²⁺ in Kombinationen von Alkalionen B' = K⁺, Na⁺ mit 5-wertigen Metallionen B"⁵⁺ = Nb, Ta, Sb), wobei

| | |
|---|---|
| x | = 0,40-0,55 |
| u | = > 0-0,10 |
| (w | = 0-1 Gew.%) |
| | |
| Me⁵⁺ | = Nb⁵⁺, Ta⁵⁺, Sb⁵⁺ bedeutet. |

Überraschenderweise wurde festgestellt, daß die erfindungsgemäßen Keramikmaterialien sich durch eine hervorragende thermische und zeitliche Stabilität der funktionellen Kenngrößen auszeichnen. Dabei zeichnen sich die erfindungsgemäßen Keramikmaterialien durch folgende Stabilitätskriterien aus:

| | | |
|---|---|---|
| - Temperaturkoeffizienten | TKε | < 3·10⁻³K⁻¹ |
| (-40...+150 °C) | Tkₖ | < 1·10⁻³K⁻¹ |
| | | |
| - Alterungsraten | Cε | < 1·10⁻²/Dekade |
| | cₖ | < 5·10⁻³/Dekade |
| | | |
| - Curietemperatur | Tc | > 300°C |
| | | |
| - Spannungsänderung bei wiederholter mechan.Belastung (Epot = 30 mWs = 250 mm Fallhöhe einer Kugel von 11,8 g, nach 1000 Stößen) | ΔU/U | < 3% |

Die ternären und quaternären festen Lösungen mit heterovalenten Substituenten (Ionenkombinationen mit Ladungskompensation) lassen sich als stöchiometrische, einphasige Zusammensetzung über die konventionelle Route der sog. Mischoxidtechnik in Totalsynthese aufbereiten.

Die so hergestellten Keramiken sintern überraschenderweise bei Temperaturen unterhalb 1150 °C, so daß einer Verdampfung von PbO weitgehend entgegengewirkt wird.

Mit den erfindungsgemäßen Werkstoffen sind in bestimmten Zusammensetzungsbereichen auch für Multilayer-Aktoren geeignete Werkstoffe mit niedriger Sintertemperatur, großem Dehnungseffekt und hoher Curietemperatur verfügbar.

Die erfindungsgemäßen Werkstoffe zeichnen sich insbesondere durch geringe Alterungsraten und Temperaturkoeffizienten der funktionellen Kenngrößen aus und sind daher für Sensoren besonders geeignet.

Aufgrund ihrer hohen Depolarisationsfestigkeit bei wiederholter mechanischer Stoß-Belastung sind die erfindungsgemäßen Werkstoffe auch für Zündelemente geeignet.

Die stabilisierten erfindungsgemäßen piezokeramischen Werkstoffe mit großer piezoelektiischer Aktivität können vorzugsweise für die Sensorik und Aktorik und in bestimmten Fällen für Zündelemente zum Einsatz kommen.

Die nachfolgenden Beispiele sollen die Erfindung erläutern, ohne sie jedoch einzuschränken:

### Ternäre feste Lösungen

### Beispiel 1:

Erfindungsgemäß hergestellt wurde folgende Verbindung:
0,98Pb(Zr_{0,52}Ti_{0,48})O₃-0,02Sr(K_{0,25}Nb_{0,75})O₃

Dazu wurden die Rohstoffe als Metalloxide beziehungsweise -carbonate oder - niobate entsprechend der stöchiometrischen Zusammensetzung eingewogen und in einem geeigneten Medium in einer Kugelmühle über einen Zeitraum von 10 h gemischt und gemahlen. Anschließend wurde die Mischung getrocknet, bei einer Temperatur von 850 °C kalziniert, feingemahlen, in einem Sprühtrockner granuliert und dann unter einem Druck von 100 MPa zu scheibenförmigen Prüfkörpern verpreßt. Die Prüfkörper wurden danach bei 1120 °C bei einer Haltezeit von 1 h dichtgesintert. Erhalten wurden runde Scheiben mit einem Durchmesser von 10 mm und einer Dicke von 1 mm.

An den so erhaltenen Prüfkörper wurden nach Metallisierung durch Einbrennen einer Silbersiebdruckpaste und Polung mit einer Spannung von 2,5 kV über eine Zeit von 5 min bei einer Temperatur von 100 °C die funktionellen Kenngrößen ermittelt. Dazu wurde u.a. folgendes Meßgerät benutzt:
Impedanz Analyser HP 4194 A für die Messung der Kapazität (Dielektrizitätszahl) und der elektromechanischen Kenngröße kₚ nach dem Resonator-Meßverfahren im Einklang mit DIN IEC 483.

Für die Prüfkörper gemäß Beispiel 1 ergaben sich folgende Meßwerte:

| | |
|---|---|
| ε₃₃^{T}/εₒ | 1989 |
| tanδ | 0,012 |
| T_{c} | 347,3 °C |
| kₚ | 0,63 |
| d₃₃ | 440·10⁻¹²m/V |
| TK_{ε} | 2,5·10⁻³K⁻¹ |
| Tkₖ | -5,2·10⁻⁴K⁻¹ |
| c_{ε} | -2,9·10⁻³/Dekade |
| cₖ | 1,7·10⁻³/Dekade |
| Tₛ | 1120 °C |

### Beispiel 2:

Wie in Beispiel 1 beschrieben wurde die Verbindung:

0,98Pb(Zr_{0,53}Ti_{0,47})O₃-0,02Sr(K_{0,25}Nb_{0,75})O₃

hergestellt.

Für die Prüfkörper gemäß Beispiel 2 ergaben sich folgende Meßwerte:

| | |
|---|---|
| ε₃₃^{T}/εₒ | 2220 |
| tanδ | 0,015 |
| T_{c} | 331,1 °C |
| kₚ | 0,63 |
| d₃₃ | 475·10⁻¹²m/V |
| TK_{ε} | 1,9·10⁻³K⁻¹ |
| Tkₖ | -5,9·10⁻⁴K⁻¹ |
| c_{ε} | -9,4·10⁻³/Dekade |
| cₖ | 2,6·10⁻³/Dekade |
| Tₛ | 1120 °C |

## Patentansprüche

1. Piezoelektrisches Keramikmaterial auf Basis von Bleizirkonattitanat, **dadurch gekennzeichnet, dass** es der allgemeinen Formulierung
(1-u)Pb(ZrₓTi₁₋ₓ)O₃-uA²⁺(B'_{0,25}¹⁺B"_{0,75}⁵⁺)O₃(+wMe₂⁵⁺O₅)
entspricht, worin
A²⁺ für Erdalkalimetallionen, vorzugsweise für Sr²⁺ und/oder Ba²⁺,
B' für Alkalimetall, vorzugsweise für Na und/oder K,
B" und Me für ein 5-wertiges Metall aus der Reihe Nb, Ta oder Sb, vorzugsweise für Nb steht und x, u und w die folgende Bedeutung haben:
| | | |
|---|---|---|
| 0,40 | ≤ x ≤ | 0,55 |
| 0 | < u ≤ | 0,10 |
| (0 | ≤ w ≤ | 1 Gew.%) |
und das dadurch herstellbar ist, dass in Bleizirkonattitanat die entsprechenden bleifreien Perowskite der allgemeinen Zusammensetzung A²⁺B'_{0,25}¹⁺B"_{0,75}⁵⁺O₃ über ternäre bzw. quaternäre feste Lösungen stöchiometrisch eingebaut werden, wobei die Rohstoffe als Metalloxide bzw. -carbonate eingesetzt, nach der Mischoxid-Route verarbeitet und die erhaltenen Grünkörper bei einer Sintertemperatur von <1150 °C dichtgesintert werden.

2. Piezoelektrisches Keramikmaterial gemäß Anspruch 1, **dadurch gekennzeichnet, dass** für das Kation A²⁺ eine Kombination der Ionen Sr²⁺ und Ba²⁺ in einem bestimmten Konzentrationsverhältnis, vorzugsweise die Kombinationen Sr_{0,7}Ba_{0,3}, Sr_{0,75}Ba_{0,25} oder Sr_{0,8}Ba_{0,2}, besonders bevorzugt die Kombination Sr_{0,75}Ba_{0,25} steht.

3. Piezoelektrisches Keramikmaterial gemäß Anspruch 1, **dadurch gekennzeichnet, dass** es der Formel
0,98Pb(Zr_{0,52}Ti_{0,48})O₃-0,02Sr(K_{0,25}Nb_{0,75})O₃
oder
0,98Pb(Zr_{0,53}Ti_{0,47})O₃-0,02Sr(K_{0,25}Nb_{0,75})O₃
entspricht.

4. Piezoelektrisches Keramikmaterial gemäß einem oder mehreren der Ansprüche 1 bis 3, **dadurch gekennzeichnet; dass** es folgende Stabilitätskriterien erfüllt:
| | | |
|---|---|---|
| - Temperaturkoeffizienten (-40-+150 °C) | TK_{ε} | < 3·10⁻³K⁻¹ |
| | Tkₖ | < 1·10⁻³K⁻¹ |
| - Alterungsraten | c_{ε} | < 1·10⁻²/Dekade |
| | cₖ | < 5·10⁻³/Dekade |
| - Curietemperatur | T_{c} | > 300°C |
| - Spannungsänderung bei wiederholter mechan, Belastung (Epot = 30 mWₛ = 250 mm Fallhöhe einer Kugel von 11,8 g, nach 1000 Stößen) | ΔU/U | < 3% |

5. Verfahren zur Herstellung eines piezoelektrischen Keramikmaterials gemäß einem der Ansprüche 1 bis 4, **dadurch gekennzeichnet, dass** in Bleizirkonattitanat die entsprechenden bleifreien Perowskite der allgemeinen Zusammensetzung A²⁺B'_{0,25}¹⁺B"_{0,75}⁵⁺O₃ über ternäre bzw. quaternäre feste Lösungen stöchiometrisch eingebaut werden, wobei die Rohstoffe als Metalloxide bzw. -carbonate eingesetzt, nach der Mischoxid-Route verarbeitet und die erhaltenen Grünkörper bei einer Sintertemperatur von < 1150 °C dichtgesintert werden.

6. Verwendung des piezoelektrischen Keramikmaterials gemäß einem der Ansprüche 1 bis 4 für Sensoren.

7. Verwendung des piezoelektrischen Keramikmaterials gemäß einem der Ansprüche 1 bis 4 für Aktoren.

8. Verwendung des piezoelektrischen Keramikmaterials gemäß einem der Ansprüche 1 bis 4 für Zündelemente.

## Claims

1. A piezoelectric ceramic material based on lead zirconate titanate, **characterised in that** it corresponds to the general formulation:
(1-u)Pb(ZrₓTi₁₋ₓ)O₃-uA²⁺(B'_{0.25}¹⁺B"_{0.75}⁵⁺)O₃(+wMe₂⁵⁺O₅),
wherein
A²⁺ stands for alkaline earth metal ions, preferably for Sr²⁺ and/or Ba²⁺,
B' stands for alkali metal, preferably for Na and/or K,
B" and Me stand for a 5-valent metal from the series Nb, Ta or Sb, preferably for Nb, and x, u and w have the following meaning:
| | | |
|---|---|---|
| 0.40 | ≤ x ≤ | 0.55 |
| 0 | < u ≤ | 0.10 |
| (0 | ≤ w ≤ | 1 % by weight), |
and which can be prepared **in that** in lead zirconate titanate the corresponding lead-free perovskites having the general composition A²⁺B'_{0.25}¹⁺B"_{0.75}⁵⁺O₃ are built in stoichiometrically by way of ternary or quaternary solid solutions, wherein the raw materials are used in the form of metal oxides or metal carbonates, processed according to the mixed oxide route and the green bodies obtained are dense-sintered at a sintering temperature of < 1150°C.

2. A piezoelectric ceramic material according to claim 1, **characterised in that** a combination of the Sr²⁺ and Ba²⁺ ions in a certain concentration ratio, preferably the combinations Sr_{0.7}Ba_{0.3}, Sr_{0.75}Ba_{0.25}, or Sr_{0.8}Ba_{0.2}, particularly preferably the combination Sr_{0.75}Ba_{0.25}, stands for the cation A²⁺.

3. A piezoelectric ceramic material according to claim 1, **characterised in that** it corresponds to the formula:
0.98Pb(Zr_{0.52}Ti_{0.48})O₃-0.02Sr(K_{0.25}Nb_{0.75})O₃
or
0.98Pb(Zr_{0.53}Ti_{0.47})O₃-0.02Sr(K_{0.25}Nb_{0.75})O₃.

4. A piezoelectric ceramic material according to one or more of claims 1 to 3, **characterised in that** it fulfils the following stability criteria:
| | | |
|---|---|---|
| - temperature coefficients | TK_{ε} | < 3·10⁻³K⁻¹ |
| (-40-+150 °C) | Tkₖ | < 1·10⁻³K⁻¹ |
| - ageing rates | c_{ε} | < 1·10⁻²/decade |
| | cₖ | < 5·10⁻³/decade |
| - Curie temperature | T_{c} | > 300°C |
| - change of strain in the case of repeated mechanical loading (Epot = 30 mWs = 250 mm height of fall of a ball weighing 11.8 g, after 1000 impacts). | ΔU/U | < 3% |

5. Method for preparing a piezoelectric ceramic material according to one of claims 1 to 4, **characterised in that** in lead zirconate titanate the corresponding lead-free perovskites having the general composition A²⁺B'_{0.25}¹⁺B"_{0.75}⁵⁺O₃ are built in stoichiometrically by way of ternary or quaternary solid solutions, wherein the raw materials are used in the form of metal oxides or metal carbonates, processed according to the mixed oxide route and the green bodies obtained are dense-sintered at a sintering temperature of < 1150°C.

6. Use of the piezoelectric ceramic material according to one of claims 1 to 4 for sensors.

7. Use of the piezoelectric ceramic material according to one of claims 1 to 4 for actuators.

8. Use of the piezoelectric ceramic material according to one of claims 1 to 4 for ignition elements.

## Revendications

1. Matériau céramique piézoélectrique à base de zirconate-titanate de plomb, **caractérisé en ce qu'**il correspond à la formulation générale
(1-u)Pb(ZrₓTi₁₋ₓ)O₃-uA²⁺(B'_{0,25}¹⁺B"_{0,75}⁵⁺)O₃(+wMe₂⁵⁺O₅),
dans laquelle
A²⁺ désigne des ions de métaux alcalinoterreux, de préférence Sr²⁺ et/ou Ba²⁺,
B' désigne un métal alcalin, de préférence Na et/ou K,
B" et Me désignent un métal pentavalent de la série Nb, Ta ou Sb, de préférence Nb, et x, u et w ont la signification suivante :
| | | |
|---|---|---|
| 0,40 | ≤ x ≤ | 0,55 |
| 0 | < u ≤ | 0,10 |
| (0 | ≤ w ≤ | 1 % en poids) |
et qui peut être fabriqué par le fait que les pérovskites exemptes de plomb correspondantes, ayant la composition générale A²⁺B'_{0,25}¹⁺B"_{0,75}⁵⁺O₃, sont insérées par stoechiométrie dans du zirconate-titanate de plomb, par l'intermédiaire de solutions solides ternaires ou quaternaires, les matières premières étant utilisées en tant qu'oxydes métalliques ou carbonates métalliques et mises en oeuvre selon la méthode des oxydes mixtes, et les corps verts obtenus étant frittés à densité maximale à une température de frittage de < 1150°C.

2. Matériau céramique piézoélectrique selon la revendication 1, **caractérisé en ce que** le cation A²⁺ est une combinaison des ions Sr²⁺ et Ba²⁺ dans un rapport de concentration défini, de préférence la combinaison Sr_{0,7}Ba_{0,3}, Sr_{0,75}Ba_{0,25} ou Sr_{0,8}Ba_{0,2}, et de manière particulièrement avantageuse la combinaison Sr_{0,75}Ba_{0,25}.

3. Matériau céramique piézoélectrique selon la revendication 1, **caractérisé en ce qu'**il correspond à la formule
0,98Pb(Zr_{0,52}Ti_{0,48})O₃-0,02Sr(K_{0,25}Nb_{0,75})O₃
ou
0,98Pb(Zr_{0,53}Ti_{0,47})O₃-0,02Sr(K_{0,25}Nb_{0,75})O₃.

4. Matériau céramique piézoélectrique selon une ou plusieurs des revendications 1 à 3, **caractérisé en ce qu'**il satisfait aux critères de stabilité suivants :
| | | |
|---|---|---|
| - coefficient de température | TK_{ε} | < 3· 10⁻³K⁻¹ |
| (-40-+150°C) | TKₖ | < 1· 10⁻³K⁻¹ |
| | | |
| - taux de vieillissement | c_{ε} | < 1· 10⁻²/décennie |
| | cₖ | < 5· 10⁻³/décennie |
| | | |
| - température de Curie | T_{C} | > 300°C |
| | | |
| - Variation de tension en cas de sollicitation mécanique répétée (Epot = 30 mWₛ = 250 mm hauteur de chute d'une bille de11,8g, après 1000 impacts) | ΔU/U | < 3% |

5. Procédé de fabrication d'un matériau céramique piézoélectrique selon l'une des revendications 1 à 4, **caractérisé en ce que** les pérovskites exemptes de plomb correspondantes, ayant la composition générale A²⁺B'_{0,25}¹⁺B"_{0,75}⁵⁺O₃, sont insérées par stoechiométrie dans du zirconate-titanate de plomb, par l'intermédiaire de solutions solides ternaires ou quaternaires, les matières premières étant utilisées en tant qu'oxydes métalliques ou carbonates métalliques et mises en oeuvre selon la méthode des oxydes mixtes, et les corps verts obtenus étant frittés à densité maximale à une température de frittage de < 1150°C.

6. Utilisation du matériau céramique piézoélectrique selon l'une des revendications 1 à 4 pour des capteurs.

7. Utilisation du matériau céramique piézoélectrique selon l'une des revendications 1 à 4 pour des actionneurs.

8. Utilisation du matériau céramique piézoélectrique selon l'une des revendications 1 à 4 pour des éléments d'allumage.
